# EUROPEAN PATENT APPLICATION

(11) **EP 3 470 866 A1**
(43) Date of publication of application: **17.04.2019**
(21) Application number: 17196628.6
(22) Date of filing: 16.10.2017
(51) Int. Cl.: G01R 33/48, G01R 33/56, G01R 33/561, G01R 33/563, G01R 33/565, G01R 33/567

(54) **MOTION SIGNAL RESOLVED MAGNETIC RESONANCE IMAGING**

(71) Applicant: Koninklijke Philips N.V., 5656 AE Eindhoven (NL)
(72) Inventor: WUELBERN, Jan Hendrik, 5656 AE Eindhoven (NL); NIELSEN, Tim, 5656 AE Eindhoven (NL); BECK, Gabriele Marianne, 5656 AE Eindhoven (NL)
(74) Representative: de Haan, Poul Erik

(57) **Abstract**

The invention provides for a magnetic resonance imaging system (100, 400). Machine executable instructions (140) cause a processor (134) controlling the magnetic resonance imaging system to control (200) the magnetic resonance imaging system with the pulse sequence commands to a acquire the time series of the magnetic resonance data. The pulse sequence commands are configured for acquiring the time series of magnetic resonance data using a k-space sampling profile (608) that is transformed rotationally in k-space for individual sub-acquisitions of the time series of magnetic resonance data. The machine executable instructions further cause the processor to: receive (202) a motion signal (146) from a motion detector (124, 402, 406) during the acquisition of the time series of the magnetic resonance data; select (204) at least one chosen sub-acquisition (150) from the individual sub-acquisitions of the time series of magnetic resonance imaging data using a predetermined criteria (148); determine (206) a selected motion signal value range (152) using a motion signal value of the at least one chosen sub-acquisition; select (208) supplementary sub-acquisitions (154) of the time series of the magnetic resonance imaging data by comparing the motion signal value of the individual sub-acquisitions of the time series of the magnetic resonance imaging data to the selected motion signal value range; create (210) combined magnetic resonance imaging data (156) by appending k-space data of the selected supplementary sub-acquisitions of the time series of the magnetic resonance imaging data to k-space data of the at least one chosen sub-acquisition, wherein the k-space data of the selected supplementary sub-acquisitions are filtered using a k-space data filter before appending to the k-space data of the at least one chosen sub-acquisition; and reconstruct (212) a magnetic resonance image (158) from the combined magnetic resonance imaging data.

## Description

### FIELD OF THE INVENTION

The invention relates to magnetic resonance imaging, in particular to the imaging of a subject that is resolved using a motion signal.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially using MRI. Several quantities which may be measured quantitatively measured are the relaxation times related to the decay of a Nuclear Magnetic Resonance (NMR) signal. For example the T1 relaxation time can be measured using T1 weighted pulse sequences. Magnetic resonance imaging contrast agents can be injected into a subject which may cause a large change in the local T1 relaxation time. If a contrast agent is injected into an artery magnetic resonance imaging system can be used to track the spread of the contrast agent through the subject. T1 weighted image will therefore provide a stark contrast between blood with contrast agent and tissues immediately adjacent to the blood.

United States Patent application US 2015/0077112 A1 discloses a method, system and computer-accessible medium which facilitates an acquisition of radial data, which can be continuous, with an exemplary golden-angle procedure and reconstruction with arbitrary temporal resolution at arbitrary time points. According to such exemplary embodiment, such procedure can be performed with a combination of compressed sensing and parallel imaging to offer a significant improvement, for example in the reconstruction of highly undersampled data. It is also possible to provide an exemplary procedure for highly-accelerated dynamic magnetic resonance imaging using Golden-Angle radial sampling and multicoil compressed sensing reconstruction, called Golden-angle Radial Sparse Parallel MRI (GRASP).

### SUMMARY OF THE INVENTION

The invention provides for a magnetic resonance imaging system, a computer program product and a method in the independent claims. Embodiments are given in the dependent claims.3

Embodiments may provide for an improved method of measuring magnetic resonance images where the contrast in the image is varying more rapidly than the acquisition time for a fully k-space sampled magnetic resonance image (e.g. like in DCE-MRI imaging). Embodiments may achieve this by continually sampling k-space with a k-space sampling profile that is rotated to a different rotational position in k-space for each sub-acquisition. The term sub-acquisition as used herein refers to an acquisition of magnetic resonance imaging data for an individual k-space sampling profile. At the same time a motion signal is monitored or received. Values of the motion signal can therefore be assigned or associated with each sub-acquisition.

After each of the sub-acquisitions has been acquired, the sub-acquisitions form a time sequence of magnetic resonance data. At least one chosen sub-acquisitions can be selected from the sub-acquisitions using a predetermined criteria. For example the predetermined criteria could be acquisitions made within a particular time window or delay after a contrast agent was injected into an artery feeding the heart. The motion signal of the at least one chosen sub-acquisition can be determined, which is then used to determine a selected motion signal value range that is descriptive of the motion state of the subject when the at least one chosen sub-acquisitions were acquired: This provides a selected motion signal value range.

The selected motion signal value range is then used to select supplementary sub-acquisitions from the sub-acquisitions of the magnetic resonance data that have a motion state of the subject that is equivalent to when the at least one chosen sub-acquisition was acquired.

The supplementary sub-acquisitions and the at least one chosen sub-acquisitions are then combined into combined magnetic resonance imaging data. Since the k-space profile was rotated to different positions for the sub-acquisitions they provide complementary information in k-space. Before the supplementary sub-acquisitions are appended to the combined magnetic resonance imaging data they are filtered using a k-space data filter.

In one particular example the k-space data filter could be used to either remove k-space data from a central region of the supplementary sub-acquisitions or to de-emphasize them by scaling or applying a distribution. The central region of k-space has a large effect on the contrast of the image and the outer region of k-space contains a large amount of information about the fine structure and details in an image. The at least one chosen sub-acquisition therefore provides contrast information for the image, and the supplementary sub-acquisitions have had part of their contrast information removed, but contribute to the fine details of the image. This may enable the measurement of the contrast information for an image to be measured rapidly or in great temporal resolution and then to supplement the structure of the image with k-space data acquired at other times.

In one aspect, the invention provides for a magnetic resonance imaging system for acquiring a time series of magnetic resonance data from a subject. A time series magnetic resonance data as used herein encompasses multiple sub-acquisitions of magnetic resonance data made sequentially in time. The magnetic resonance imaging system comprises a memory for storing machine-executable instructions and pulse sequence commands. Pulse sequence commands as used herein encompass either instructions which can be used directly for controlling a magnetic resonance imaging system to acquire magnetic resonance data or data or meta data which can be converted into such instructions.

The pulse sequence commands are configured for controlling the magnetic resonance imaging system to acquire the time series of magnetic resonance data. The pulse sequence commands are configured for acquiring the time series of magnetic resonance data using a k-space sampling profile. The k-space sampling profile is transformed rotationally in k-space for the individual sub-acquisitions of the time series of magnetic resonance data. In other words, for each of the individual sub-acquisitions the k-space sampling profile is rotated to a different orientation in k-space. In some examples the central region of k-space sampling profile is sufficiently sampled with respect to the Nyquist theorem and the outer region of k-space is under sampled with respect to the Nyquist theorem.

The magnetic resonance imaging system further comprises a motion detector configured for providing a motion signal descriptive of a motion of a subject. The motion detector could for example be configured to monitor the heart, breathing, or other motion of the subject. Specific examples of a motion detector are described later below.

The magnetic resonance imaging system further comprises a processor configured for controlling the magnetic resonance imaging system. Execution of the machine-executable instructions cause the processor to control the magnetic resonance imaging system with the pulse sequence commands to acquire the time series of the magnetic resonance data. Execution of the machine-executable instructions further cause the processor to receive the motion signal from the motion detector during the sub-acquisition of the time series of the magnetic resonance data. A motion signal value for each of the individual sub-acquisitions of the time series of the magnetic resonance imaging data is determined.

Execution of the machine-executable instructions further cause the processor to select at least one chosen sub-acquisition from the individual sub-acquisitions of the time series of magnetic resonance imaging data using a predetermined criteria. The predetermined criteria may take different forms in different examples. In some case the predetermined criteria might be a criteria that selects a particular motion signal initially. In other instances the predetermined criteria can be based on external factors or data. For example, the predetermined criteria might be an interval or a time delay from a specific event such as a subject being injected with a contrast agent.

Execution of the machine-executable instructions further cause the processor to determine a selected motion signal value range using a motion signal value of the at least one chosen sub-acquisition. For example an equation or mapping might be used to select the motion signal value range from the motion signal value of the at least one chosen sub-acquisition. Execution of the machine-executable instructions further cause the processor to select supplementary sub-acquisitions of the time series of the magnetic resonance imaging data by comparing the motion signal value of the individual sub-acquisitions of the time series of the magnetic resonance imaging data to the selected motion signal value range. In this step the selected motion signal value range is used to select the supplementary sub-acquisitions. The selected motion signal value range may be equivalent to the subject being in a particular position or having a particular phase of some internal motion such as a breathing position or a heart phase.

Execution of the machine-executable instructions further cause the processor to create combined magnetic resonance imaging data by appending k-space data of the selected supplementary sub-acquisitions of the time series of the magnetic resonance imaging data to k-space data of the at least one chosen sub-acquisition. The k-space data of the selected supplementary sub-acquisitions are filtered using a k-space data filter before appending to the k-space data of the at least one chosen sub-acquisition.

The k-space data filter may take different forms in different examples. In one example the k-space data filter is used to selectively remove k-space data from the central region of k-space. In other examples the k-space data filter may be used to weight or scale down portions of the k-space data selectively. It may be used for example for de-emphasizing the central region of k-space. Execution of the machine-executable instructions further cause the processor to reconstruct a magnetic resonance image from the combined magnetic resonance imaging data. The effect of combining the magnetic resonance imaging data using the k-space data filter is that the central k-space data is provided for only or emphasized only in the at least one chosen sub-acquisition. The higher portions of k-space are contributed to more or selectively by the supplementary sub-acquisitions. The central k-space region is important in providing for the contrast within the image. The higher portions of the k-space contribute to the fine details of the image more.

This may have many applications. For example when it is desired to sample a heart after a contrast agent has been injected it may be impossible to acquire the full amount of magnetic resonance data within the phase of the heart that is desired to be examined. This may allow the injection of a contrast agent and then to select a part which is most important for showing the contrast when the contrast agent is peaking and in the proper position. The other sub-acquisitions when the heart is in the same phase can be used to help to provide the fine details for the magnetic resonance image.

This embodiment may also have applications in other instances where there is a time sensitivity which limits how long the magnetic resonance data can be acquired. For example this may also be useful in arterial spin labeling or also in such things as detecting a catheter within a subject.

In another embodiment, the time series of magnetic resonance data is reconstructed according to a compressed sensing magnetic resonance imaging protocol.

In another embodiment, the k-space sampling profile is a radial k-space sampling patter, a spiral k-space sampling pattern, or a koosh-ball k-space sampling pattern. In these embodiments a central region of the k-space pattern is oversampled or inherently oversampled. In some of these embodiments, an outer region of k-space (the region outside of the central region of k-space) is under sampled.

In another embodiment, the k-space data filter is configured for selectively removing the k-space data from the central region of k-space.

In another embodiment, the pulse sequence commands are configured for acquiring the time series magnetic resonance data from a subject according to a T1 weighted magnetic resonance imaging protocol. The predetermined criteria comprises a chosen time. The chosen time could for example be a delay or time selected in relation to when a contrast agent or other substance is injected into a subject. This embodiment maybe beneficial for contrast-enhanced images. The chosen time, as mentioned before, maybe a specific time, a delay or it could be a time determined by the injection of a contrast agent.

In another embodiment, execution of the machine-executable instructions further cause the processor to receive an ECG signal. The individual sub-acquisitions of the time series of magnetic resonance imaging data are triggered using the ECG signal. The motion detector is a respiratory motion detector. This embodiment may be beneficial particularly for contrast enhanced imaging of the heart. The individual sub-acquisitions are triggered by the ECG signal and then the motion detector monitors the respiratory motion of the subject. This may eliminate the need for so called held breath techniques.

In different examples, the respiratory motion detector could take different forms. For example it maybe a camera system to measure chest motion or fiducial markers located on the subject's chest. The respiratory motion detector could also be a magnetic resonance imaging navigator that is acquired. The respiratory motion detector could also be a respiratory sensor or tube that measures patient breath. The respiratory motion detector could also be a belt with a sensor to measure expansion of the subject's abdomen.

In another embodiment, the memory further comprises arterial spin labeling pulse sequence instructions configured for performing an arterial spin labeling protocol. The arterial spin labeling pulse sequence instructions comprise the pulse sequence commands. The pulse sequence commands are configured for acquiring the series of magnetic resonance data according to a T1 weighted magnetic resonance imaging protocol. Execution of the machine-executable instructions further cause the processor to perform the steps of acquiring the time series of magnetic resonance data through reconstruction of the magnetic resonance image from the combined magnetic resonance imaging data to provide a background image. Execution of the machine-executable instructions further cause the processor to label a bolus of blood according to the Arterial Spin Labeling (ASL) protocol by controlling the magnetic resonance imaging system with the ASL pulse sequence instructions.

Execution of the machine-executable instructions further cause the processor to perform the step of acquiring the time series of magnetic resonance data through reconstruction with the magnetic resonance image from the combined magnetic resonance imaging data a second time to provide a labeled image. Execution of the machine-executable instructions further cause the processor to subtract the background image from the labeled image to construct an arterial spin labeled magnetic resonance image. This embodiment may be beneficial because it may provide for arterial spin labeled magnetic resonance images that can be acquired with a higher degree of temporal resolution.

In another embodiment, the pulse sequence commands are according to a T1 weighted magnetic resonance imaging protocol.

In another embodiment, the pulse sequence commands are according to a T2 weighted magnetic resonance imaging protocol.

In another embodiment, the pulse sequence commands are according to a gradient echo magnetic resonance imaging protocol T2. In another embodiment, the pulse sequence commands are according to a spin-echo magnetic resonance imaging protocol.

In another embodiment, the magnetic resonance imaging system comprises a catheter and a display. The steps of controlling the magnetic resonance imaging system with the pulse sequence commands to acquire the time series of magnetic resonance data through reconstructing the magnetic resonance image from the combined magnetic resonance imaging data is performed repeatedly. Execution of the machine-executable instructions further cause the processor to display the magnetic resonance image on the display to indicate a position of the catheter. This embodiment may be beneficial because it may provide for a means of displaying a position of a catheter with respect to particular anatomy positions that are determined by the motion signal.

In some examples, the catheter could be filled with a contrast agent or have a magnetic resonance marker or fiducial marker built into it that are used to locate the catheter. This contrast agent or the magnetic resonance imaging marker or fiducial marker may have a large contrast in the magnetic resonance image. The combining of the magnetic resonance imaging data as described herein may therefore be used to show the position of the catheter.

In another embodiment, the predetermined criteria comprises an interval of time. The motion signal has a period. The interval time is any one of the following: at least two times longer than the period, at least four times longer than the period, and at least ten times longer than the period. This embodiment may be beneficial because it enables the synchronizing of two intervals of time or periodic motions which have different timescales.

In another embodiment, the predetermined criteria comprises any one of the following: a delay from a chosen time, an interval from a chosen time, and an interval from a previous sub-acquisition of the at least one chosen acquisition, and combinations thereof.

In another embodiment, the motion detector comprises any one of the following: an ECG system, an optical motion sensor, a camera-based motion sensor, a three-dimensional camera, a breathing tube sensor, a chest expansion belt, an optical fiducial marker detector, a magnetic resonance imaging fiducial marker detector, a magnetic resonance imaging navigator, and combinations thereof. This embodiment may be beneficial because any of these above mentioned motion detectors maybe used to generate a signal which can be descriptive of a particular position of the subject.

In another embodiment the motion detector comprises the magnetic resonance imaging system and the motion signal is derived or calculate from an intrinsic navigator. The motion signal could for example be derived from the central region of k-space of each of the individual sub-acquisitions. This would be advantageous because an external motion sensor or additional data acquisition for a navigator is not needed.

In another embodiment, the steps of controlling the magnetic resonance imaging system with the pulse sequence commands to acquire the time series of magnetic resonance data through the reconstruction of a magnetic resonance image from the combined magnetic resonance imaging data is performed at multiple times. This embodiment may be beneficial because it enables a magnetic resonance imaging system to synchronize several different timescales effectively.

In another embodiment, the filter is configured for removing the central region of k-space using a step function that removes all k-space data within the central region.

In another embodiment, the filter is configured for removing the central k-space using a distribution that progressively removes more k-space data closer to the central region.

In another embodiment, the filter is configured for reducing a signal value of k-space data in the central region. This may be useful for de-emphasizing the k-space data within the supplementary sub-acquisitions.

In another embodiment, the filter is configured for weighting the k-space data according to a weighting function. This embodiment may also be beneficial for reducing the importance of k-space data in the central region of the supplementary sub-acquisitions. In the above embodiments complete k-space lines may also be removed.

In another embodiment, the k-space sampling profile is a radial sampling pattern.

In another embodiment, the k-space sampling profile is a Koosh ball sampling pattern.

In another embodiment, the k-space sampling profile is a spiral sampling pattern.

In the embodiments with the radial sampling pattern, the Koosh ball sampling pattern, and the spiral sampling pattern it may be beneficial because they can be rotated to different positions and provide different spaces within k-space that are sampled. The outer portions of the k-space data are then complimentary and contribute to a finer detail in the final magnetic resonance image.

In another embodiment, the k-space sampling profile is transformed rotationally between the individual sub-acquisitions by rotating it by the golden mean or a multiple of the golden mean. This may be beneficial because it may help to ensure that the same k-space data portion is not sampled more than once.

In another aspect, the invention provides for a computer program product comprising machine-executable instructions for execution by a processor. Execution of the machine-executable instructions cause the processor to receive a time series of magnetic resonance imaging data descriptive of a subject. Execution of the machine-executable instructions further cause the processor to receive a motion signal descriptive of a motion of the subject during acquisition of the time series of magnetic resonance data. The motion signal and individual sub-acquisitions of the time series of magnetic resonance imaging data may be time stamped so that it can be correlated or else portions of the motion signal descriptive of the motion of the subject maybe associated with the time series of the magnetic resonance imaging data.

Execution of the machine-executable instructions further cause the processor to select at least one chosen sub-acquisition from the individual sub-acquisitions of a time series of magnetic resonance imaging data using a predetermined criteria. This for example may be sub-acquisition that was acquired within a certain time window. The time series of magnetic resonance data is sampled using a k-space sampling profile that is transformed rotationally in k-space for each of the individual sub-acquisitions. Execution of the machine-executable instructions further cause the processor to determine a selected motion signal value range using a motion signal value of the at least one chosen sub-acquisition. Execution of the machine-executable instructions further cause the processor to select supplementary sub-acquisitions of the time series of the magnetic resonance data by comparing the motion signal value of the individual sub-acquisitions of the time series of magnetic resonance imaging data to the selected motion signal value range.

Execution of the machine-executable instructions further cause the processor to create combined magnetic resonance imaging data by appending k-space data of the selected supplementary sub-acquisitions of the time series of the magnetic resonance imaging data to k-space data of the at least one chosen sub-acquisition. The k-space data of the selected supplementary sub-acquisitions are filtered using a k-space data filter before appending to the k-space data of the at least one chosen sub-acquisition. The k-space data filter is configured for selectively removing k-space data from the central region of the k-space. Execution of the machine-executable instructions further cause the processor to reconstruct a magnetic resonance image from the combined magnetic resonance imaging data. The advantages of this embodiment have been previously discussed.

In another embodiment, the processor is configured for controlling the magnetic resonance imaging system. The magnetic resonance imaging system comprises a motion detector configured for providing a motion signal descriptive of the motion of the subject. The step of receiving a time series of magnetic resonance imaging data descriptive of a subject comprises controlling the magnetic resonance imaging system with the pulse sequence commands to acquire the time series of the magnetic resonance data. The pulse sequence commands are configured for acquiring the time series of magnetic resonance data. The pulse sequence commands are configured for acquiring the time series of the magnetic resonance data using a k-space sampling profile. The k-space sampling profile is transformed rotationally in k-space for individual sub-acquisitions of the time series of magnetic resonance data.

The step of receiving a motion signal descriptive of a motion of the subject during acquisition of the time series of magnetic resonance data comprises receiving the motion signal from the motion detector during the acquisition of the time series of the magnetic resonance data. The motion signal value for each of the individual sub-acquisitions of the time series of the magnetic resonance imaging data is determined.

In another aspect, the invention provides for a method of operating a magnetic resonance imaging system. The magnetic resonance imaging system comprises a motion detector configured for providing a motion signal descriptive of a motion of the subject. The method comprises controlling the magnetic resonance imaging system with pulse sequence commands to acquire the time series of the magnetic resonance data. The pulse sequence commands are configured for acquiring the time series of magnetic resonance data using a k-space sampling profile. The k-space sampling profile is transformed rotationally in k-space between individual sub-acquisitions of the time series of magnetic resonance data.

The method further comprises receiving the motion signal from the motion detector during the acquisition of the time series of magnetic resonance data. A motion signal value for each of the individual sub-acquisitions of the time series of magnetic resonance data is determined. The method further comprises selecting at least one chosen sub-acquisition from the individual sub-acquisitions of the time series of magnetic resonance imaging data using a predetermined criteria. The method further comprises determining a selected motion signal value range using a motion signal value of the at least one chosen sub-acquisition. The method further comprises selecting supplementary sub-acquisitions of the time series of magnetic resonance imaging data by comparing the motion signal value of the individual sub-acquisitions of the time series of the magnetic resonance imaging data to the selected motion signal value range.

The method further comprises creating combined magnetic resonance imaging data by appending k-space data of the selected supplementary sub-acquisitions of the time series of the magnetic resonance imaging data to k-space data of the at least one chosen sub-acquisition. The k-space data of the selected supplementary sub-acquisitions are filtered using a k-space data filter before appending to the k-space data of the at least one chosen sub-acquisition. The k-space data filter is configured for selectively removing k-space data from the central region of k-space. The method further comprises reconstructing the magnetic resonance image from the combined magnetic resonance imaging data. The advantages of this embodiment have been previously discussed.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) maybe utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network. Computer executable code embodied on a computer readable medium maybe transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection maybe made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

Magnetic Resonance (MR) data is defined herein as being the recorded measurements of radio frequency signals emitted by atomic spins using the antenna of a Magnetic resonance apparatus during a magnetic resonance imaging scan. MRF magnetic resonance data is magnetic resonance data. Magnetic resonance data is an example of medical image data. A Magnetic Resonance Imaging (MRI) image or MR image is defined herein as being the reconstructed two or three dimensional visualization of anatomic data contained within the magnetic resonance imaging data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a magnetic resonance imaging system;
Fig. 2 shows a flow chart which illustrates a method of operating the magnetic resonance imaging system of Fig. 1;
Fig. 3 shows a flow chart which illustrates a further method of operating the magnetic resonance imaging system of Fig. 1;
Fig. 4 illustrates a further example of a magnetic resonance imaging system;
Fig. 5 illustrates a further example of a magnetic resonance imaging system; and
Fig. 6 graphically illustrates an example of a DCE magnetic resonance imaging protocol.

### DETAILED DESCRIPTION OF THE EMBODIMENTS

Like numbered elements in these figures are either equivalent elements or perform the same function. Elements which have been discussed previously will not necessarily be discussed in later figures if the function is equivalent.

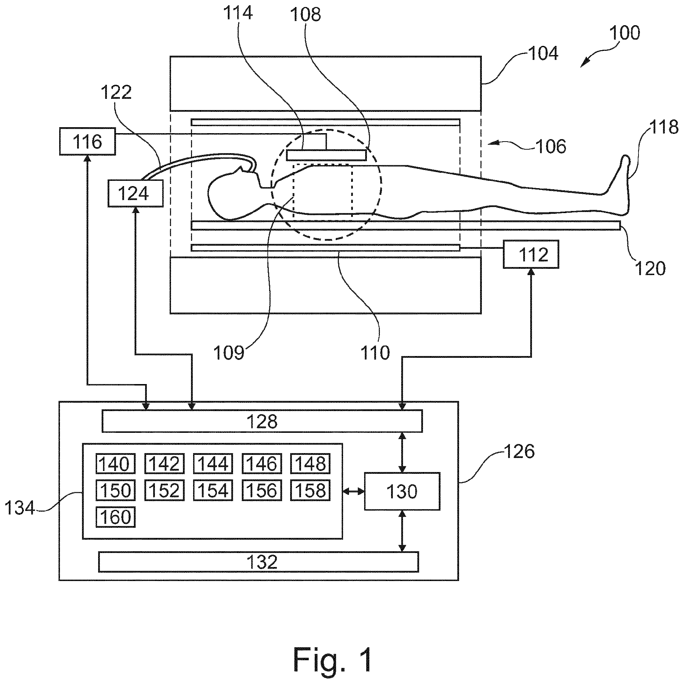

Fig. 1 shows an example of a magnetic resonance imaging system 100 with a magnet 104. The magnet 104 is a superconducting cylindrical type magnet with a bore 106 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils. Within the bore 106 of the cylindrical magnet 104 there is an imaging zone 108 where the magnetic field is strong and uniform enough to perform magnetic resonance imaging. A region of interest 109 is shown within the imaging zone 108. A subject 118 is shown as being supported by a subject support 120 such that at least a portion of the subject 118 is within the imaging zone 108 and the region of interest 109.

Within the bore 106 of the magnet there is also a set of magnetic field gradient coils 110 which is used for acquisition of preliminary magnetic resonance data to spatially encode magnetic spins within the imaging zone 108 of the magnet 104. The magnetic field gradient coils 110 connected to a magnetic field gradient coil power supply 112. The magnetic field gradient coils 110 are intended to be representative. Typically magnetic field gradient coils 110 contain three separate sets of coils for spatially encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio-frequency coil 114 for manipulating the orientations of magnetic spins within the imaging zone 108 and for receiving radio transmissions from spins also within the imaging zone 108. The radio frequency antenna may contain multiple coil elements. The radio frequency antenna may also be referred to as a channel or antenna. The radio-frequency coil 114 is connected to a radio frequency transceiver 116. The radio-frequency coil 114 and radio frequency transceiver 116 may be replaced by separate transmit and receive coils and a separate transmitter and receiver. It is understood that the radio-frequency coil 114 and the radio frequency transceiver 116 are representative. The radio-frequency coil 114 is intended to also represent a dedicated transmit antenna and a dedicated receive antenna. Likewise the transceiver 116 may also represent a separate transmitter and receivers. The radio-frequency coil 114 may also have multiple receive/transmit elements and the radio frequency transceiver 116 may have multiple receive/transmit channels. For example if a parallel imaging technique such as SENSE is performed, the radio-frequency could 114 will have multiple coil elements.

It can be seen that the subject 118 has a breathing tube 124 that is connected to a breathing sensor 124. The breathing sensor 124 is one example of a motion detector that could be used. The breathing sensor 124 may be replaced with different types of motion sensors.

The transceiver 116, the breathing sensor 124, and the gradient controller 112 are shown as being connected to a hardware interface 128 of a computer system 126. The computer system further comprises a processor 130 that is in communication with the hardware system 128, a memory 134, and a user interface 132. The memory 134 may be any combination of memory which is accessible to the processor 130. This may include such things as main memory, cached memory, and also non-volatile memory such as flash RAM, hard drives, or other storage devices. In some examples the memory 130 maybe considered to be a non-transitory computer-readable medium.

The memory 134 is shown as containing machine-executable instructions 140. The machine-executable instructions enable the processor 130 to perform basic functions to control the operation and function of the magnetic resonance imaging system 100 and also to manipulate data and perform calculations. The memory 134 is further shown as containing the pulse sequence commands 142. The memory 134 is further shown as containing a time series of magnetic resonance data 144. The time series of magnetic resonance data 144 was acquired using the pulse sequence commands 142. The time series of magnetic resonance data 144 is made up of sub-acquisitions. Each sub-acquisition was acquired using a k-space sampling profile. In the time series of magnetic resonance data 144, the sub-acquisitions use the same k-space sampling profile that is related rotationally. Between different sub-acquisitions the k-space sampling profile is rotated in k-space.

The memory 134 is further shown as containing a motion signal 146. The motion signal 146 is acquired at the same time as the time series of magnetic resonance data 144. The time series 144 and the motion signal 146 may for example be time stamped or otherwise correlated so that the motion signal for individual sub-acquisitions can be determined.

The memory 134 is further shown as containing a predetermined criteria 148. The predetermined criteria 148 is a criteria which when fulfilled causes the processor 130 to select at least one chosen sub-acquisition 150 from the time series of magnetic resonance data 144. The predetermined criteria 148 could be for example measurements from a sensor or even at a particular time or delay from a different time. The computer memory 134 is further shown as containing at least one chosen sub-acquisition 150 that was selected from the time series of magnetic resonance data 144 using the predetermined criteria 148. The computer memory 134 is further shown as containing a selection motion signal value range that was determined by using the motion signal for the at least one chosen sub-acquisition. The computer memory 134 is further shown as containing supplementary sub-acquisitions 154. The supplementary sub-acquisitions 154 are sub-acquisitions of the time series of magnetic resonance data that have motion signal values that are within the selected motion signal values range 152. The computer memory 134 is further shown as having a combined magnetic resonance imaging data 156. The combined magnetic resonance imaging data 156 is a combination of the magnetic resonance data from the at least one chosen sub-acquisition 150 and also from the selected motion signal value range 152. The supplementary sub-acquisitions 154 were filtered with a k-space data filter before being appended to the combined magnetic resonance imaging data 156. The computer memory 134 is then shown as containing a magnetic resonance image 158 that was reconstructed from the combined magnetic resonance imaging data 156.

The computer memory 134 is also shown as containing a second magnetic resonance image 160. The process of acquiring the magnetic resonance image 158 can be performed repeatedly and a series of magnetic resonance images 158, 160 can be reconstructed.

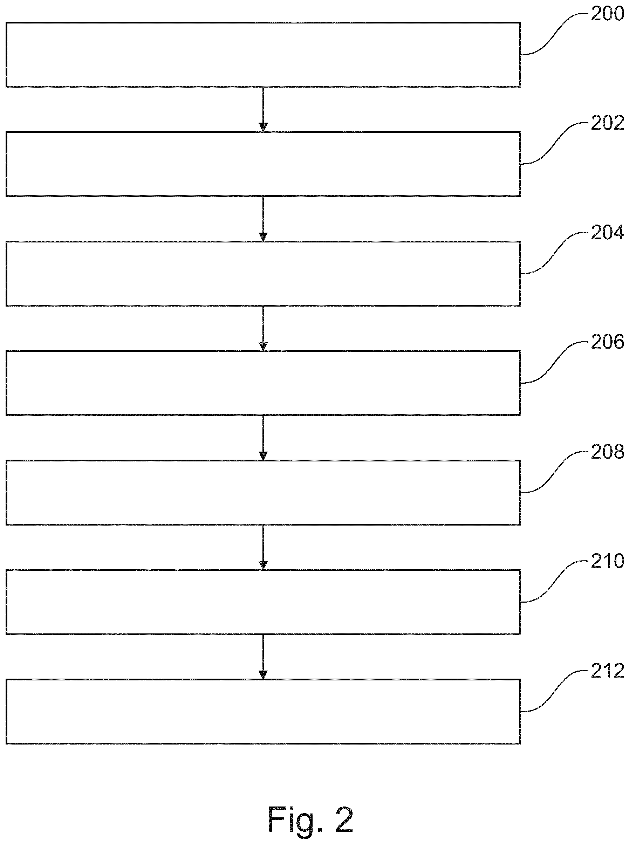

Fig. 2 shows a flowchart which illustrates a method of operating the magnetic resonance imaging system 100 of Fig. 1. First in step 200 the magnetic resonance imaging system 100 is controlled with the pulse sequence commands 142 to acquire the time series of magnetic resonance data 144. Next in step 202, the motion signal 146 is received from the motion detector 124 during acquisition of the time series of magnetic resonance data 144. A motion signal value for each of the individual sub-acquisitions of the time series of magnetic resonance data is determined. Then in step 204, at least one chosen sub-acquisition 150 is selected from the individual sub-acquisitions of the time series of magnetic resonance data 144 using a predetermined criteria 148.

Next in step 206, a selected motion signal value range 152 is determined using the motion signal value of the at least one chosen sub-acquisition. Then in step 208, at least one supplementary sub-acquisition 154 of the time series of magnetic resonance data 144 is selected by comparing the motion signal value of the individual sub-acquisitions of the time series of magnetic resonance data 144 to the selected motion signal value range 152. Next in step 210, combined magnetic resonance imaging data 156 is created by appending k-space data of the supplementary sub-acquisitions of the time series of magnetic resonance imaging data to the k-space data of the at least one chosen sub-acquisition. The k-space data of the selected supplementary sub-acquisition are filtered using a k-space data filter before appending to the k-space data of the at least one chosen sub-acquisition. The k-space data filter could for example be implemented in the machine-executable instructions 140. Finally, in step 212, the magnetic resonance image 158 is reconstructed from the combined magnetic resonance imaging data 156.

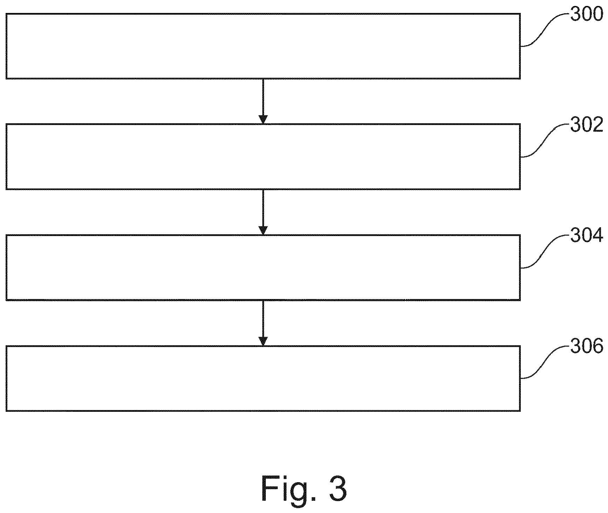

Fig. 3 shows a flowchart which illustrates a further example of a method for operating the magnetic resonance imaging system 100 of Fig. 1. In Fig. 3 it is explained how the method of Fig. 2 can be used to construct an arterial spin labeled magnetic resonance image. The method illustrated in Fig. 3 is broken down into four steps. The pulse sequence commands maybe configured for acquiring the time series of magnetic resonance data according to a T1 weighted magnetic resonance imaging protocol. The magnetic resonance imaging instructions may also be part of arterial spin labeling or ASL pulse sequence instructions. The ASL pulse sequence instructions are not illustrated in Fig. 1. First in step 300 all of steps 200-212 of Fig. 2 are performed. This is used to provide a background image or background magnetic resonance image.

Next in step 302 a bolus of blood is labeled according to the arterial spin labeling protocol by controlling the magnetic resonance imaging system with ASL pulse sequence instructions. After this has been performed, next in step 304, the steps of acquiring the time series of magnetic resonance data through the reconstruction of the magnetic resonance image, as illustrated in steps 200-212, are performed a second time. This provides for a labeled image which is a magnetic resonance image. Then in step 306 the background image is subtracted from the labeled image and used to construct an arterial spin labeled magnetic resonance image. Using the illustration of Fig. 1 the background image could for example be the magnetic resonance image 158 and the labeled image could be the second magnetic resonance image 160.

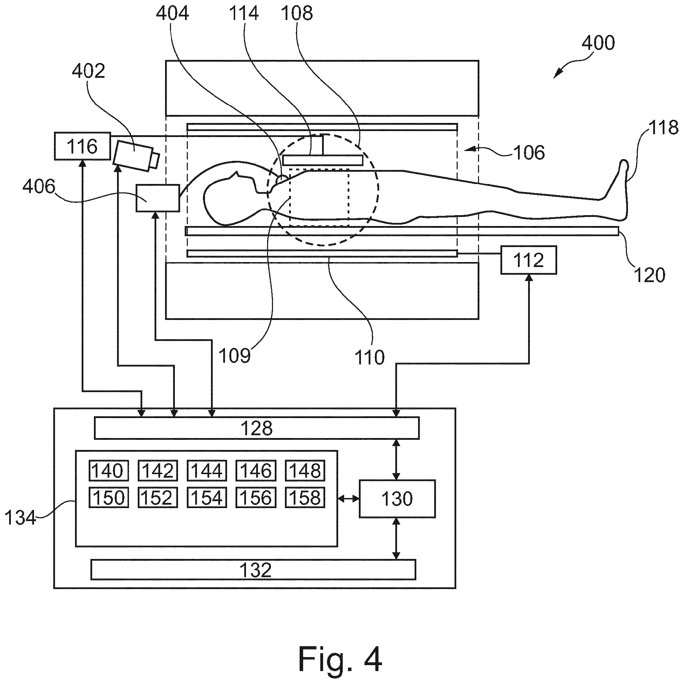

Fig. 4 shows a further example of a magnetic resonance imaging system 400. The magnetic resonance imaging system 400 of Fig. 4 is similar to the magnetic resonance imaging system 100 of Fig. 1. In this example the breathing sensor 124 of Fig. 1 has been replaced with a camera 402 that is able to observe the thorax region of the subject 118. The camera 402 could for example be used to monitor the breathing of the subject 118 and also to detect gross motion or changes in position of the subject 118 also. The subject 118 is further shown as having an electrode 404 on its chest. The electrode 404 is representative of multiple EEG electrodes and is connected to an EEG system 406. The camera 402 and the EEG system 406 are further connected to the hardware interface 128. The pulse sequence commands 142 in this example could for example be a T1 weighted magnetic resonance imaging protocol. The individual sub-acquisitions could be triggered by a particular phase of the signal generated by the EEG system 406. The predetermined criteria could for example be a chosen time. The chosen time could for example be a delay after a contrast agent is injected into the subject 118. In this example the camera 402 supplies the motion signal 146. The example illustrated in Fig. 4 may be useful for performing contrast-enhanced imaging of the subject's heart 118.

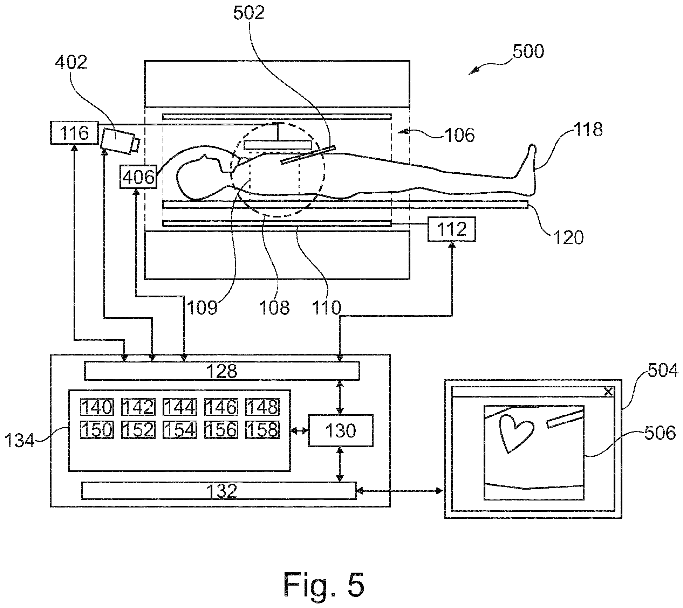

Fig. 5 shows a further example of a magnetic resonance imaging system 500. The magnetic resonance imaging system 500 of Fig. 5 is similar to the magnetic resonance imaging system 400 of Fig. 4. In this example there can additionally be seen a catheter 502 that has been inserted into the subject 118. The catheter is partially within the region of interest 109. The catheter 502 may for example contain material that shows a high contrast in a magnetic resonance image. The method illustrated in Fig. 2 may be performed repeatedly to repeatedly acquire the magnetic resonance image 158. The magnetic resonance image 158 can be displayed on a display 504. The display 504 is shown as showing a rendering 506 of the magnetic resonance image 158. By performing the steps shown in Fig. 2 multiple times the position of the catheter 502 can be tracked relative to the subject's 118 internal anatomy. This can be done so that the resulting series of images 158 are correlated to one or more motion signals 146.

Examples may in some cases use a K-space Weighted Image Contrast (KWIC) like reconstruction to combine radially acquired data to reconstruct the arterial phase of a contrast enhanced MRI exam without motion or undersampling artifacts. Due to the short temporal window of the arterial phase, the acquired data acquired of this contrast phase is not sufficient to fulfill the Nyquist criterion for high resolution scans. Examples may use data acquired during other contrast phases, but equivalent motion states to fill the outer k-space regions. This procedures maintains the image contrast and ensures reconstruction of motion artifact free images.

Magnetic resonance tomography is a valuable imaging modality of the human body as it offers excellent soft tissue contrast without the use of ionizing radiation. A major disadvantage of MRI is its long acquisition time which, depending on the imaging volume and resolution may range from tens of seconds up to several minutes. As such the acquisition is prone to motion artifacts due to movements of the subject during the scan. This is particularly problematic if organs in the abdomen are under investigation, which are subject to respiratory or cardiac motion. Respiratory motion is commonly compensated by instructing the patient to hold its breath for the duration of image acquisition. This is only possible if the scan time is below the order of approximately 15 seconds and if the patient is able to hold its breath for the required time interval. To overcome this limitation gating or trigger techniques may be employed which result in prolonged scan time and reduced scan efficiency.

Acquisition of the k-space with, for example, radial trajectories rather than Cartesian sampling reduces the problem of motion artifacts. Blurring and streaking artifacts are typical in images acquired with rotating readout, however are considered to be more benign than the ghosting artifacts observed with Cartesian trajectories.

Radial trajectories massively oversample the k-space centre. By weighting of the acquired readouts differently during reconstruction one may adjust the desired temporal and spatial resolution retrospectively (k-space weighted image contrast, KWIC). The golden angle profile order enhances this flexibility even further as it ensures quasi random k-space coverage allowing arbitrary selection of acquisition profile window size, position and fusing of windows. Golden angle radially sampled data from a free breathing examination is very well suited for KWIC-like reconstruction schemes where k-space profiles from adjacent temporal positions are used to fill outer parts of the k-space.

In dynamic contrast enhanced (DCE) MRI imaging of the arterial phase contrast is particularly challenging as the time window of interest is very short (typically 5 seconds or less), and requires very good timing for the acquisition and good breath-holding reaction of the patient. Using continuous golden angle radial acquisition on a free breathing patient, allows retrospective selection of the acquisition window and thus relaxes the burden on the patient as well as operator. Including data only from the narrow time window around maximum signal enhancement will give good contrast, however at either a low resolution image or strong streaking artifacts in the image. A possible solution would include more data from adjacent time points, filling the outer k-space regions following the KWIC-method without compromising the overall image contrast. However, due to respiratory motion it is likely that the motion state of the data used for filling the k-space does not fit the motion state of the maximum arterial phase. Alternatively compressed sensing approaches may be used to compensate for the incomplete data set at a particular motions state and contrast phase combination, which however dramatically increases the computational burden on the reconstruction and with today's computing hardware still results in several hours of reconstruction time.

Imaging of the arterial phase contrast during DCE MRI remains a challenging task which requires a skilled operator and cooperative patient to produce a satisfying imaging result with today's state of the art clinical methods (Cartesian k-space sampling and breath-hold). This makes the procedure error prone and increases the possibility of failed exams, requiring rescans. This is a burden on the patient as well as produces extra cost. Reported solutions to this problem require either compromise on image resolution, artifact level or extensive reconstruction effort.

Exemplary reconstruction process may in some cases be based on radially acquired data during a free breathing examination, sorting the data according to motion state and fusing the data from equivalent motion states followed by a standard non-Cartesian reconstruction. The additional computational effort for the sorting and fusing is minimal, without significantly prolonging reconstruction time and still producing high resolution images without under sampling or motion artifacts.

Example may possibly overcomes afore listed problems by KWIC-like combination of radial profiles from different contrast enhancement phases with similar motion states. Profiles from the maximum contrast enhancement temporal window constitute the central k-space and outer k-space region. Profiles from matching motion state but differing contrast phase are used to fill the outer k-space regions only. Therefore this method ensures that the outer k-space regions are filled with matching motion state data, the overall image contrast is set by the contrast phase of interest and the image is free of streaking artifacts from incomplete data or corrupted motion data.

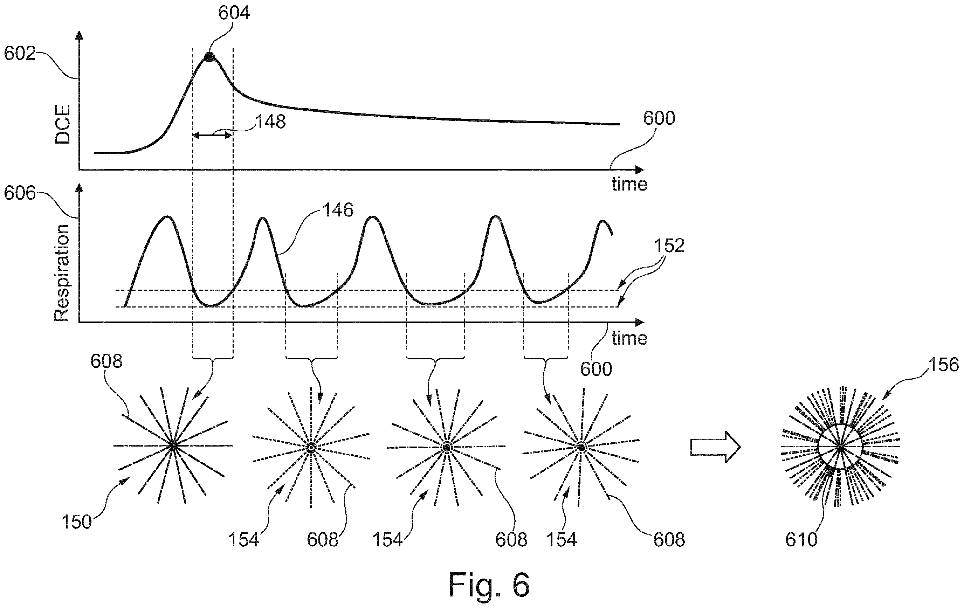

Examples may in some cases use a reconstruction method modifies the reconstruction pipeline of continuously (in some cases radially) acquired magnetic resonance imaging data. Exemplary contrast and motion navigator signals are sketched in Fig. 6 below. After acquisition, the radial readouts are sorted according to motion state and contrast phase. Then the profiles from the temporal window around the maximum contrast enhancement are selected and the corresponding motion state is identified. If the profiles from the maximum enhancement and motion state are not sufficient to fulfill the Nyquist criterion, the outer k-space regions are filled with data from fitting motion states. Since the contrast of the image is defined by the data at the central k-space region, the maximum contrast enhancement is retained with this procedure.

Fig. 6 illustrates an example of a method graphically. There are several plots shown. In the uppermost plot a graph of the contrast agent concentration 602 versus time 600 is shown. The amount of contrast agent peaks at time indicated by the point 604. The dashed lines represent a time interval when it is desired to acquire magnetic resonance data for examining the effects of the contrast agent. This time interval is equivalent to the predetermined criteria 148. The plot below the contrast agent concentration 602 is a plot of time 600 versus a respiratory phase 606. The plot of respiration 606 versus time 600 is the motion signal 146 in this example. The dotted lines indicated by 148 are projected down onto the plot of respiration 606 versus time 600 and used to determine a selected motion signal value range 152. Below the plot of respiration versus time is shown as number of k-space profiles 608.

The first was acquired during the time indicated by the predetermined criteria 148. This is then the at least one chosen sub-acquisition 150. When the respiration signal 146 is within the selected motion signal value range 152 additional supplementary sub-acquisitions 154 were also selected. It can be seen that the k-space profiles 608 are rotated with respect to each other in k-space data. The at least one chosen sub-acquisition 150 and the supplementary sub-acquisitions 154 are all used to create a combined magnetic resonance imaging data 156. In this example it can be seen that the complete at least one chosen sub-acquisition 150 is appended to the combined magnetic resonance imaging data. The supplementary sub-acquisitions 154 were also appended to the combined magnetic resonance imaging data 156 however, a k-space data filter was first applied to the supplementary sub-acquisitions 154.

In this example the filter removed k-space data from the supplementary sub-acquisitions 154 that were within a central region of k-space 610. In different examples the filter could function differently. For example a distribution could be used to selectively reduce the amount of k-space data within the central region 610. In other examples there may be a weighting to the k-space data such that the k-space data from the central region 610 of the supplementary sub-acquisitions 154 is given less weight.

In Fig. 6, the respiration signal 606 could be derived from Navigator signals describing the contrast enhancement and respiratory motion. Radial data subsets are selected according to their contrast phase and motion state. In this example, only profiles (154) of matching motion state are combined, profiles which do not match the arterial enhancement phase fill the outer k-space regions. The central k-space is filled by profiles of correction motion state and contrast phase.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### LIST OF REFERENCE NUMERALS

100 magnetic resonance imaging system
104 magnet
106 bore of magnet
108 imaging zone
109 region of interest
110 magnetic field gradient coils
112 magnetic field gradient coil power supply
114 radio-frequency coil
116 transceiver
118 subject
120 subject support
122 breating tube
124 breathing sensor
126 computer system
128 hardware interface
130 processor
132 user interface
134 computer memory
140 machine executable instructions
142 pulse sequence commands
144 time series of magnetic resonance data
146 motion signal
148 predetermined criteria
150 at least one chosen sub-acquisition
152 selected motion signal value range
154 supplementary sub aquisitions
156 combined magnetic resonance imaging data
158 magnetic resonance image
160 second magnetic resonance image
200 control the magnetic resonance imaging system with the pulse sequence commands to acquire the time series of the magnetic resonance data
202 receive the motion signal from the motion detector during the acquisition of the time series of the magnetic resonance data, wherein a motion signal value for each of the individual sub-acquisitions of the time series of the magnetic resonance imaging data is determined
204 select at least one chosen sub-acquisition from the individual sub-acquisitions of the time series of magnetic resonance imaging data using a predetermined criteria
206 determine a selected motion signal value range using a motion signal value of the at least one chosen sub-acquisition
208 select supplementary sub-acquisitions of the time series of the magnetic resonance imaging data by comparing the motion signal value of the individual sub- acquisitions of the time series of the magnetic resonance imaging data to the selected motion signal value range
210 create combined magnetic resonance imaging data by appending k-space data of the selected supplementary sub-acquisitions of the time series of the magnetic resonance imaging data to k-space data of the at least one chosen sub-acquisition
212 reconstruct a magnetic resonance image from the combined magnetic resonance imaging data.
300 perform the steps of acquiring the time series of magnetic resonance data through reconstruction of the magnetic resonance image from the combined magnetic resonance imaging data to provide a background image
302 label a bolus of blood according to the arterial spin labeling protocol by controlling the magnetic resonance imaging system with the ASL pulse sequence instructions
304 perform the steps of acquiring the time series of magnetic resonance data through reconstruction of the magnetic resonance image from the combined magnetic resonance imaging data a second time to provide a labeled image
306 subtract the background image from the labeled image to construct an arterial spin labeled magnetic resonance image
400 magnetic resonace imaging system
402 camera
404 electrode
406 EEG system
500 magnetic resonance imaging system
502 catheter
504 display
506 rendering of magnetic resonance image 158
600 time
602 concentration of contrast agent
604 peak of concentration
606 respiratory phase
608 k-space profile
610 central region of k-space

## Claims

1. A magnetic resonance imaging system (100, 400) for acquiring a time series of magnetic resonance data (144) from a subject (118), wherein the magnetic resonance imaging system comprises:
a memory (134) for storing machine executable instructions (140) and pulse sequence commands (142), wherein the pulse sequence commands are configured controlling the magnetic resonance imaging system to acquire the time series of magnetic resonance data, wherein the pulse sequence commands are configured for acquiring the time series of magnetic resonance data using a k-space sampling profile (608), wherein the k-space sampling profile is transformed rotationally in k-space for individual sub-acquisitions of the time series of magnetic resonance data;
a motion detector (124, 402, 406) configured for providing a motion signal (146) descriptive of a motion of the subject; and
a processor (134) configured for controlling the magnetic resonance imaging system, wherein execution of the machine executable instructions causes the processor to:
control (200) the magnetic resonance imaging system with the pulse sequence commands to acquire the time series of the magnetic resonance data;
receive (202) the motion signal from the motion detector during the acquisition of the time series of the magnetic resonance data, wherein a motion signal value for each of the individual sub-acquisitions of the time series of the magnetic resonance imaging data is determined;
select (204) at least one chosen sub-acquisition (150) from the individual sub-acquisitions of the time series of magnetic resonance imaging data using a predetermined criteria (148);
determine (206) a selected motion signal value range (152) using a motion signal value of the at least one chosen sub-acquisition;
select (208) supplementary sub-acquisitions (154) of the time series of the magnetic resonance imaging data by comparing the motion signal value of the individual sub-acquisitions of the time series of the magnetic resonance imaging data to the selected motion signal value range;
create (210) combined magnetic resonance imaging data (156) by appending k-space data of the selected supplementary sub-acquisitions of the time series of the magnetic resonance imaging data to k-space data of the at least one chosen sub-acquisition, wherein the k-space data of the selected supplementary sub-acquisitions are filtered using a k-space data filter before appending to the k-space data of the at least one chosen sub-acquisition; and
reconstruct (212) a magnetic resonance image (158) from the combined magnetic resonance imaging data.

2. The magnetic resonance imaging system of claim 1, wherein the pulse sequence commands are configured for acquiring the time series of magnetic resonance data from a subject according to a T1 weighted magnetic resonance imaging protocol, and wherein the predetermined criteria comprises a chosen time.

3. The magnetic resonance imaging system of claim 2, wherein execution of the machine executable instructions further causes the processor to receive an ECG signal, wherein the individual sub-acquisitions of the time series of magnetic resonance imaging data are triggered using the ECG signal, and wherein the motion detector is a respiratory motion detector (124, 402).

4. The magnetic resonance imaging system of claim 1, wherein the memory further comprises ASL pulse sequence instructions configured for performing an arterial spin labeling protocol, wherein the ASL pulse sequence instructions comprise the pulse sequence commands, wherein the pulse sequence commands are configured for acquiring the time series of magnetic resonance data according to a T1 weighted magnetic resonance imaging protocol, wherein execution of the machine executable instructions further cause the processor to:
perform (300, 200, 202, 204, 206, 208, 210, 212) the steps of acquiring (200) the time series of magnetic resonance data through reconstruction (212) of the magnetic resonance image from the combined magnetic resonance imaging data to provide a background image (158);
label (302) a bolus of blood according to the arterial spin labeling protocol by controlling the magnetic resonance imaging system with the ASL pulse sequence instructions;
perform (304, 200, 202, 204, 206, 208, 210, 212) the steps of acquiring (200) the time series of magnetic resonance data through reconstruction (212) of the magnetic resonance image from the combined magnetic resonance imaging data a second time to provide a labeled image (160);
subtract (306) the background image from the labeled image to construct an arterial spin labeled magnetic resonance image.

5. The magnetic resonance imaging system of claim 1, wherein the pulse sequence commands are according to any one of the following: a T1 weighted magnetic resonance imaging protocol, a T2 weighted magnetic resonance imaging protocol, a gradient echo magnetic resonance imaging protocol, and a spin-echo magnetic resonance imaging protocol.

6. The magnetic resonance imaging system of claim 1 or 5, wherein the magnetic resonance imaging system comprises a catheter (502) and a display (504), wherein the steps of controlling (200) the magnetic resonance imaging system with the pulse sequence commands to acquire the time series of the magnetic resonance data through reconstructing (212) the magnetic resonance image from the combined magnetic resonance imaging data is performed repeatedly, wherein the execution of the machine executable instructions further causes the processor to display the magnetic resonance image on the display to indicate a position of the catheter.

7. The magnetic resonance imaging system of claim 1, 4, 5, or 6, wherein the predetermined criteria comprises an interval of time (148), wherein the motion signal has a period, wherein the interval of time is any one of the following: at least two times longer than the period, at least four time longer than the period, and at least ten times longer than the period.

8. The magnetic resonance imaging system of any one of claims 1, 4, 5, 6, or 7, wherein the predetermined criteria comprises any one of the following: a delay from a chosen time, an interval from the chosen time, an interval from a previous acquisition of the at least one chosen sub-acquisition, and combinations thereof.

9. The magnetic resonance imaging system of any one of claims 1, 2, 4, 5, 6, 7, or 8, wherein the motion detector comprises any one of the following: an ECG system (506), an optical motion sensor (402), a camera based motion sensor (402), a three-dimensional camera (402), a breathing tube sensor (124), a chest expansion belt, an optical fiducial marker detector, a magnetic resonance imaging fiducial marker detector, an intrinsic magnetic resonance imaging navigator, a magnetic resonance imaging navigator, and combinations thereof.

10. The magnetic resonance imaging system of any one of the preceding claims, wherein the steps of controlling the magnetic resonance imaging system with the pulse sequence commands to acquire the time series of the magnetic resonance data through the reconstruction of the magnetic resonance image from the combined magnetic resonance imaging data is performed multiple times.

11. The magnetic resonance imaging system of any one of the preceding claims, wherein the filter is configured for any one of the following:
removing the central region of k-space using a step function that removes all k-space data within the central region;
removing the central region of k-space using a distribution that progressively removes more k-space data closer to the central region;
reducing a signal value in the central region; and
weighting the k-space data according to a weighting function.

12. The magnetic resonance imaging system of any one of the preceding claims, wherein the k-space sampling profile is any one of the following, a radial sampling pattern (608), a koosh ball sampling pattern, and a spiral sampling pattern.

13. A computer program product comprising machine executable instructions (140) for execution by a processor (130), wherein execution of the machine executable instructions causes the processor to:
receive (200) a time series of magnetic resonance imaging data (144) descriptive of a subject (118);
receive (202) a motion signal (146) descriptive of motion of the subject during acquisition of the time series of magnetic resonance data;
select (204) at least one chosen sub-acquisition (150) from individual sub-acquisitions of a time series of magnetic resonance imaging data using a predetermined criteria (148), wherein the time series of magnetic resonance data is sampled using a k-space sampling profile that is transformed rationally in k-space for each of the individual sub-acquisitions;
determine (206) a selected motion signal value range (152) using a motion signal value of the at least one chosen sub-acquisition;
select (208) supplementary sub-acquisitions (154) of the time series of the magnetic resonance imaging data by comparing the motion signal value of the individual sub-acquisitions of the time series of the magnetic resonance imaging data to the selected motion signal value range;
create (210) combined magnetic resonance imaging data (156) by appending k-space data of the selected supplementary sub-acquisitions of the time series of the magnetic resonance imaging data to k-space data of the at least one chosen sub-acquisition, wherein the k-space data of the selected supplementary sub-acquisitions are filtered using a k-space data filter before appending to the k-space data of the at least one chosen sub-acquisition; and
reconstruct (212) a magnetic resonance image (158) from the combined magnetic resonance imaging data.

14. A method of operating a magnetic resonance imaging system (100, 400), wherein the magnetic resonance imaging system comprises a motion detector (124, 402, 406) configured for providing a motion signal (146) descriptive of a motion of a subject (118), wherein the method comprises:
controlling (200) the magnetic resonance imaging system with pulse sequence commands (142) to acquire a time series of magnetic resonance data (144), wherein the pulse sequence commands are configured for controlling the magnetic resonance imaging system to acquire the time series of magnetic resonance data using a k-space sampling profile (608), wherein the k-space sampling profile is transformed rotationally in k-space for individual sub-acquisitions of the time series of magnetic resonance data;
receiving (202) the motion signal from the motion detector during the acquisition of the time series of the magnetic resonance data, wherein a motion signal value for each of the individual sub-acquisitions of the time series of the magnetic resonance imaging data is determined;
selecting (204) at least one chosen sub-acquisition (150) from the individual sub-acquisitions of the time series of magnetic resonance imaging data using a predetermined criteria (148);
determining (206) a selected motion signal value range using a motion signal value of the at least one chosen sub-acquisition;
selecting (208) supplementary sub-acquisitions (154) of the time series of the magnetic resonance imaging data by comparing the motion signal value of the individual sub-acquisitions of the time series of the magnetic resonance imaging data to the selected motion signal value range;
creating (210) combined magnetic resonance imaging data (156) by appending k-space data of the selected supplementary sub-acquisitions of the time series of the magnetic resonance imaging data to k-space data of the at least one chosen sub-acquisition, wherein the k-space data of the selected supplementary sub-acquisitions are filtered using a k-space data filter before appending to the k-space data of the at least one chosen sub-acquisition; and
reconstructing (212) a magnetic resonance image (158) from the combined magnetic resonance imaging data.
